Europäisches Patentamt

European Patent Office

Office européen des brevets

(19)

(11) Publication number: **0 402 671**

**A1**

(12) **EUROPEAN PATENT APPLICATION**

(21) Application number: **90109870.7**

(22) Date of filing: **23.05.90**

(51) Int. Cl.⁵: **B24D 3/10, B24D 18/00, C30B 29/04, C23C 16/26**

(30) Priority: **15.06.89 US 366823**

(43) Date of publication of application:
**19.12.90 Bulletin 90/51**

(84) Designated Contracting States:
**AT BE CH DE FR GB LI SE**

(71) Applicant: **GENERAL ELECTRIC COMPANY**
**1 River Road**
**Schenectady New York 12305(US)**

(72) Inventor: **Gigl, Paul Donald**
**592 Dempsey Road**
**Westerville, Ohio 43081(US)**
Inventor: **Slutz, David Earl**
**2448 Sandstrom Drive**
**Worthington, Ohio 43085(US)**

(74) Representative: **Catherine, Alain**
**General Electric France Service de Propriété**
**Industrielle 18 Rue Horace Vernet**
**F-92136 Issy-Les-Moulineaux Cedex(FR)**

(54) **Tools employing a large or irregularly shaped diamond abrasive.**

(57) There is provided a tool comprising a fully dense sheet of diamond brazed to a substrate. The diamond sheet is manufactured by a chemical vapor deposition process and has a thickness of at least about 0.1 mm. The braze material is preferably a carbide-former. A method for making such tools is also provided.

EP 0 402 671 A1

## TOOLS EMPLOYING A LARGE OR IRREGULARLY SHAPED DIAMOND ABRASIVE LAYER

Background of the Invention

The present invention generally relates to tools having a diamond abrasive layer brazed to a substrate. More particularly, the present invention relates to such tools wherein the diamond abrasive layer is fully dense polycrystalline diamond of at least about 0.1 mm thickness manufactured by a chemical vapor deposition (CVD) process. A particular advantage of such tools is that they can be of increased size and/or irregular shape.

Polycrystalline diamond compacts comprising a diamond layer bonded directly to a larger cemented carbide support mass are well known in the art, for example, as described in U. S. Patent Re. 32,380. While such polycrystalline compacts represent a significant contribution to the art in many fields of use, thermal degradation at an elevated temperature, e.g., above about 700°C, did limit their usefulness, especially in metal matrix bond applications.

Thermal stability of such polycrystalline compacts was improved with the advent of thermally stable, porous, self-bonded diamond compacts containing less than about 3 percent non-diamond phase. Compacts of this type are the subject of U. S. Patents Nos. 4,224,380 and 4,288,248 to Bovenkerk and Gigl.

European Patent Publication No. 116,403 describes a thermally stable diamond compact comprising a mass of diamond particles present in an amount of from 80 to 90 volume percent of the body and a second phase present in an amount of 10 to 20 volume percent of the body, said second phase containing nickel and silicon, the nickel being in the form of nickel and/or nickel silicide and the silicon being in the form of silicon, silicon carbide and/or nickel silicide.

British patent application no. 8508295 describes a thermally stable diamond compact comprising a mass of diamond particles present in an amount of from 80 to 90 volume percent of the compact and a second phase present in an amount of from 10 to 20 volume percent of the compact, said second phase containing silicon either as silicon metal or as silicon carbide.

As can be appreciated from the foregoing, extensive efforts have been made to provide thermally stable diamond compacts. However, diamond, whether synthetic or natural, is very difficult to wet, making attachment of diamond to a variety of substrates very difficult. Slutz, et al. in U. S. Patent Application Serial No. 158,575, filed February 22, 1988, and assigned to the same assignee as the present invention, discovered that thermally stable polycrystalline diamond compacts such as the foregoing can be more effectively brazed to a cemented carbide support using a chromium-containing braze alloy having a liquidus above about 700°C.

Because such polycrystalline diamond compacts are typically manufactured by a high pressure/high temperature process, it is not commercially feasible to manufacture large or irregularly shaped compacts.

One approach to resolving the problems associated with making large or irregularly shaped polycrystalline diamond compacts has been to manufacture diamonds by a chemical vapor deposition (CVD) process. Such CVD diamond is fully dense and can in many cases be satisfactorily deposited directly on the desired substrate. However, in many demanding applications, such as abrasive tools for example, the bond between the CVD diamond and the substrate is not sufficient to withstand normal operating conditions. Moreover, the diamond layer which is deposited on the substrate is typically very thin, i.e., several microns in thickness. Such embodiments are described in U. S. Patents Nos. 4,434,188; 4,707,384; 4,731,296; 4,734,339; 4,740,263; and 4,767,608.

European Patent Application No. 254,560 discloses CVD diamond films of from less than 10 microns thickness to more than 200 microns thickness which were deposited directly onto a substrate. However, it is clear from the specification and the examples that only thin CVD diamond films adhere to the substrate adequately for abrasive or cutting applications. See page 4, lines 37 - 42, which teaches thick films (i.e., bulk diamond), because of superior transmittance of infrared rays and the like, lend themselves to use as a transmissive material. Moreover, Example 7 suggests that the bond between the diamond film and the substrate is very weak when the diamond film is thick since no cutting test results are provided for the films having a thickness of 80, 160 and 220 microns.

European Patent Application No. 286,306 also discloses thick (i.e., greater than about 0.1 mm thickness) CVD diamond films, but again there is no teaching that such thick films can be effectively utilized in abrasive or cutting applications; see page 12, lines 45 -47.

It has now been discovered that large and/or irregularly shaped fully dense CVD diamond sheets can be brazed to a suitable substrate in order to provide improved tools. In particular, such tools permit the use of diamond tools in applications which heretofore were unavailable due to size and shape limitations.

## Summary of the Invention

It is an object of the present invention to provide tools having a fully dense diamond layer brazed to a substrate.

It is another object of the present invention to provide large and/or irregularly shaped tools having a fully dense diamond abrasive layer brazed to a substrate.

Still another object of the present invention is to provide a method for making tools, especially those having a large and/or irregularly shaped fully dense diamond layer brazed to a substrate.

It is still another object of the present invention to provide wear parts and heat transfer devices such as heat sinks which have a large surface area.

These and other objects are achieved by providing a fully dense, thermally stable diamond sheet brazed to a suitable substrate, said fully dense diamond sheet having been manufactured by a low pressure deposition process. Preferably, the large and/or irregularly shaped diamond sheet has a length of at least about 30 millimeters, and most preferably at least about 50 millimeters in its longest dimension and has a thickness of at least about 0.1 millimeters. It is especially preferred that the substrate be a cemented carbide and that the braze alloy contain a carbide-former, with chromium and titanium being the most preferred of such carbide-formers.

Tools of the present invention can be prepared by a process which comprises the steps of:

(1) growing a sheet of diamond on a surface by a low pressure deposition process such as chemical vapor deposition;

(2) removing the diamond sheet from said surface;

(3) machining the diamond sheet to dimensions which are approximately equal to those of the substrate to which it is to be brazed most often, slightly larger;

(4) disposing a braze alloy intermediate said diamond sheet and said substrate;

(5) heating the result of step (4) to a temperature sufficient to at least partly melt the braze alloy;

(6) cooling the resultant composite material; and

(7) machining the diamond layer and/or the substrate of said composite material to substantially the same dimensions.

## Description of the Invention

In its broadest aspect, the present invention provides tools comprising a fully dense, thermally stable diamond sheet manufactured by a low pressure deposition process which is brazed to a suitable substrate. Large and/or irregularly shaped diamond tools are unique to the present invention. Preferably, such tools have a longest dimension of at least about 30 mm, and most preferably at least about 50 mm, and employ a diamond layer having a thickness of at least about 0.1 mm, and preferably between 0.1 mm and 1.0 mm.

It is contemplated that any low pressure deposition process, for example, chemical vapor deposition, for making diamond can be utilized to make the diamond sheets which are brazed to the substrate. However, it should be understood that by low pressure deposition process is meant any process wherein carbon is deposited on a surface to form diamond or diamond-like material in a manner similar to CVD processes. Thus, for example, it is intended that diamond and diamond-like films prepared by ionization vapor deposition and ion beam vapor deposition are within the intended scope of the invention.

It has been found, however, that the chemical vapor deposition apparatus described in U. S. Patent Application Serial No. 234,773, Anthony, et al., assigned to the same assignee as the present invention and incorporated herein by reference is particularly effective for manufacturing diamond sheets suitable for use in the present invention.

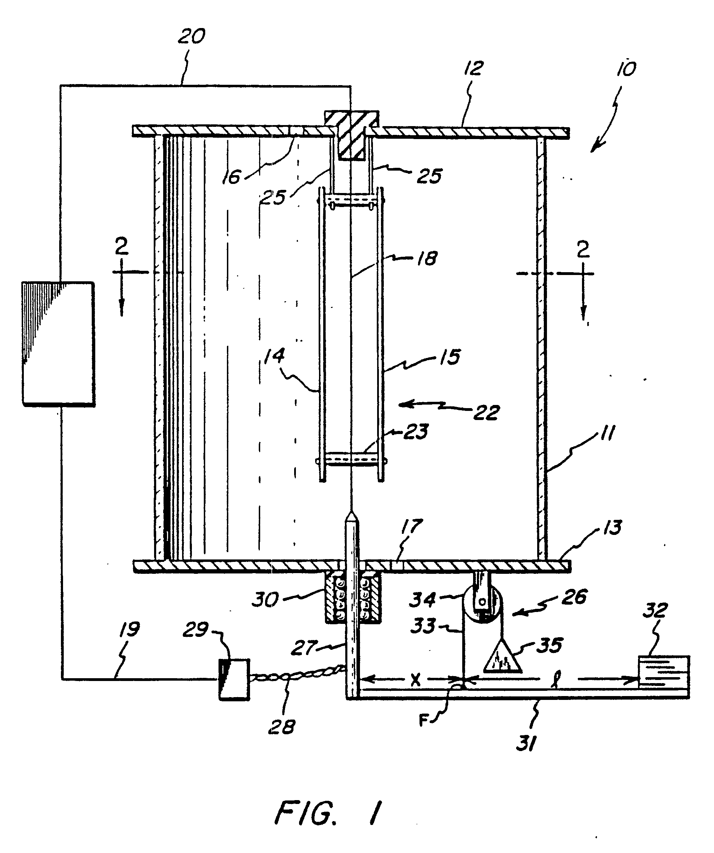

As can be seen in FIG. 1, apparatus 10 comprises a hollow cylindrical reaction chamber 11, of a high temperature resistant material such as quartz, with opposite closed end walls 12 and 13. Positioned coaxially in chamber 11 in spaced apart, planar, and opposite parallel relationship is a pair of rectangular substrate plates or panels 14 and 15. Panels 14 and 15 are suspended in parallel relationship at a predetermined fixed spacing from each other so that a gas entering chamber 11 through gas inlet 16 in closed end 12 may flow between plates 14 and 15 to exit from chamber 11 through gas exit aperture 17 in closed end 13. Between plates 14 and 15, parallel therewith, and spaced equidistantly therefrom is an electrical resistance heater in the form of a small diameter straight tungsten wire filament 18.

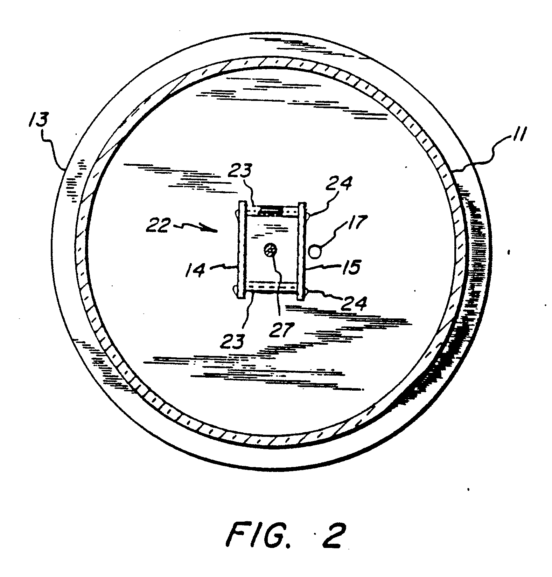

Heater filament 18 is connected by means of electrical leads 19 and 20 to a source of direct current electrical power. Filament 18 is retained in predetermined spaced relationship from substrate panels 14 and 15 coextensively along the length of panels 14 and 15. Panels 14 and 15 may be maintained in the parallel, fixed, spaced apart relationship as shown by being joined in a subassembly which is placed in chamber 11. Such a subassembly is more clearly illustrated in FIG. 2 as subassembly 22.

In FIG. 2, subassenbly 22 comprises a pair of rectangular panels 14 and 15 placed in planar juxtaposed position and retained in spaced apart parallel relationship by means of a short, small diameter quartz tube section 23 positioned at each corner of one panel such as panel 14 to extend perpendicularly from the plane of the panel to engage a complementary corner of the opposite panel 15 in perpendicular relationship. A small aperture is provided at each panel corner in axial alignment with the tube section 23. A short length of small diameter metal wire 24 such as tungsten wire is inserted through one aperture in one panel to extend through the tube section 23 and project from the opposite aperture in the opposite panel. The ends of wire 24 are bent over to retain the wire in the tube sections 23 and to fasten panels 14 and 15 to the tube sections while at the same time to fasten the tube sections to the panels. The length of tube sections 23 fixes the spaced apart dimension of the panels 14 and 15 in subassembly 22. Subassembly 22 with its plural substrate panels 14 and 15 may be conveniently hung from small J hook supports 25 as illustrated in FIG. 1.

In practicing the invention a predetermined gas mixture, for example, a hydrogen/hydrocarbon gas mixture is caused to flow into chamber 11 through gas inlet 16 in closed end 12 and to flow unimpeded between panels or plates 14 and 15 along and in contact with heater 18, and to exit from chamber 11 through a gas exit 17 in closed end 13. Heater 18 is provided with sufficient electrical current to cause it to become incandescent. Under these conditions the flow of gas cones into contact with and is activated by incandescent heater 18. The gas flow also comes into contact with panels 14 and 15 which are cooler than heater 18 to cause diamond crystal nucleation and growth on panels 14 and 15, particularly on those opposite surfaces directly exposed to heater filament 18.

Panels 14 and 15 serve as plural substrate surfaces in CVD apparatus 10, and both are served by one or more heater filaments 18. Panels 14 and 15 contain or are manufactured from those materials which are conducive to diamond nucleation and growth in a CVD process. Among the preferred materials are metals which are stable at high temperatures and in the presence of a high carbon content gas. The refractory metals represent a class of metals useful for panels 14 and 15, and molybdenum has been used with good results.

During operation, heater filament 18 remains at its incandescent temperature subject to some temperature variations brought on by environmental conditions such as minor equipment variations and the like. Temperature variations, particularly during start up from room temperature, cause the heater filament 18 to be subjected to temperature and chemically induced stresses causing flexing and embrittlement of the filament 18 with resultant changes in the spacing between the heater filament and plates 14 and 15. For best results, heater filament 18 should be maintained in a fixed space relationship to panels 14 and 15. For example, a spacing of less than about 1 cm has been found to provide good results.

Since heater filament 18 is maintained at its incandescent temperature, its intrinsic strength is significantly reduced and attachment of devices intending to maintain the described spaced relationship tend to cause filament breakage and a short useful life. As a consequence, in one embodiment of this invention a very precise force and leverage means in the form of a weight balancing assembly is utilized to maintain the spaced distance of heater filament 18 constant along the length of panels 14 and 15. One example of a weight balancing system employed in the present invention is illustrated in FIG. 1 as weight balancing assembly 26.

In carrying out a CVD process in the apparatus of FIG. 1, heater filament 18 is maintained above about 2000°C. A gas mixture of about 95-99% by volume hydrogen and about 1-5% by volume methane is introduced into reaction chamber 11 to cause a gas flow therein of from about 0.5 cc/min. to about 3 cc/min. Operating parameters of gas mixture constituents and proportions, gas flow rate, and electrical power input to heater 18 are retained constant for the appropriate period of time, with the result that panels 14 and 15 become coated with a diamond layer of from about 0.1 mm to 1.0 mm or more in thickness.

This diamond layer typically mechanically delaminates from substrate panels 14 and 15 during cooling as integral, cohesive, self-supporting diamond sheets or strips.

The resultant diamond sheets are typically polycrystalline and very highly wear resistant with no significant cleavage planes or soft wear directions. Such diamond sheets are thermally stable and can be heated to high temperature brazing conditions without damage.

In the practice of the present invention such CVD diamond sheets are cut, for example, with a laser, or machined by means well known in the art, to a size and shape which is roughly equivalent to that of the substrate to which it is to be brazed. The thus prepared diamond layer is then placed on top of a sheet of a suitable braze alloy which in turn has been placed on top of a suitable substrate having nearly the desired shape and dimensions of the finished tool. Such arrangement is then heated in a furnace maintained at a temperature above the melting point of the braze alloy for a time sufficient to at least partly melt the braze alloy and thereby cause the diamond sheet to strongly adhere to the substrate. Such a process is known in the art as furnace brazing. It should be understood, however, that tools of the present invention can be manufactured by methods other than furnace brazing, for example, according to the methods disclosed in U. S. Patent No. 4,225,322 to Knemeyer.

It is particularly preferred that the braze alloy contain a carbide-former, with chromium being the most preferred of such carbide-formers. Other carbide-forming elements which can be utilized in the preferred braze alloys include, for example, manganese, titanium, tungsten, hafnium, zirconium, vanadium, molybdenum, niobium, and tantalum. Preferably, the braze alloy should have a liquidus above 700°C but less than 1200°C, at which temperature thermal degradation of the diamond may commence. Representative metals for inclusion in the braze alloy composition include, for example, nickel, cobalt, gold, boron, palladium, silver, copper and the like.

Suitable braze alloys are described in the patent literature. One such braze alloy is disclosed in U.S. Patent No. 4,149,881 as consisting essentially of from about 17 to 44 percent by weight of palladium, from about 4 to about 11 percent by weight of chromium, from about 1 to about 4 percent by weight of silicon, from about 1.5 to about 4 percent by weight boron, with the balance being nickel.

Another suitable braze alloy is described in U. S. Patent No. 4,396,577 as consisting essentially of 25 to 95 percent by weight of palladium, up to 5 percent by weight of silicon, up to 3.5 percent by weight of boron, and the remainder being cobalt.

U. S. Patent No. 4,414,178, discloses a braze alloy consisting essentially of 28 to 32 percent by weight of palladium, about 6 to 13 percent by weight of chromium, about 1. to 3.5 percent by weight boron, and the balance being nickel, which is particularly suited for use in the present invention.

Still another braze alloy suitable for use in the present invention is disclosed in U. S. Patent No. 4,772,294, and which consists essentially of 20 to 80 percent by weight of palladium, 2 to 13 percent by weight of chromium, 1 to 4 percent by weight of boron, and the remainder being nickel.

All of the foregoing brazing alloy patents are hereby incorporated by reference into the present disclosure. Of course, other suitable materials can readily be ascertained by those skilled in the art without undue experimentation.

The substrate may be any suitable material and is typically a cemented carbide such as cemented tungsten carbide, cemented titanium carbide, cemented tungsten-molybdenum carbide, or cemented tantalum carbide. The metal bond material for the carbide is generally selected from the group consisting of cobalt, nickel, iron and mixtures thereof. Cobalt is the bond material of choice in the art as is the use of a cobalt cemented tungsten carbide substrate. The most preferred alternative to a cemented carbide substrate is a ceramic substrate such as SIALON.

It is also contemplated that tools of the present invention may have several layers of diamond. Such embodiments would be particularly useful for chip control in machining operations or depth of cut control in drill bits.

Tools manufactured in accordance with the present invention can be used for any application in which prior art tools were used. Such tools may be made of a single element or of a mosiac arrangement.

In order to better enable those skilled in the art to practice the present invention, the following examples are provided by way of illustration and should not be construed as limiting in any way. All parts are by weight unless otherwise noted.

## EXAMPLE 1

A sheet of diamond having a thickness of about 0.5 mm was prepared by the hot filament technique of chemical vapor deposition. Triangular diamond pieces having leg lengths of 4.5 mm, 5.0 mm and 6.5 mm, respectively were laser cut from the diamond sheet. The diamond was brazed to a tungsten carbide substrate using a braze alloy having a nominal composition of 22.0% nickel, 6.0% chromium and 72% gold (melting point = 975° - 1000°C).

Prior to the brazing operation, surface contamination was removed, metal parts were degreased and the diamond was acid cleaned. The parts were assembled so that the 90° triangles, braze alloy foil and tungsten carbide substrate were vertically stacked in a bonding apparatus. The bonding apparatus consisted of a RF heater with the coil around an air-actuated carbide plunger which compresses the diamond layer to the braze layer to the carbide substrate to the apparatus support. The RF coil heats the carbide plunger and the heat is transferred to the diamond layer which diffuses it to the braze layer. The braze melts and bonds to the diamond and carbide layers. This operation is accomplished in a matter of seconds and the endpoint is obtained by a combination of linear displacement of the carbide plunger relative to the system support and the visual detection of braze flow. Temperature quench was obtained by turning off the RF power at the occurrence of braze alloy melting and the end of thinning of the braze as determined by the end of braze flow.

The resultant brazed sanples were shaped by diamond grinding and polishing operations. In order to test their performance, the 4.5 mm leg length sample and the 6.5 mm leg length sample were brazed into tool shanks. The samples were tested against a 390 aluminum workpiece under dry conditions at a surface speed of 2200 SFPM, a 0.020 inch depth of cut and a 0.005 inch ipr feed rate. The tools were resharpened twice to test the quality versus diamond relative to depth. Tests were run on each. The CVD diamond tools performed as well as to slightly better than polycrystalline diamond tools. Performance was similar after each resharpening.

In a second test, samples were bonded to a 0.5 inch square carbide insert and firnished as a 90° insert. The tools were run at the same conditions as the first test but with only one test per tool. Again, the CVD diamond tools performed as well as to slightly better than polycrystalline diamond tools made by high pressure/high temperature techniques.

EXAMPLE 2

Samples were prepared in the same manner as in Example 1, except that the braze alloy had a nominal composition of 55.9% nickel, 10.5% chromium, 2.5% boron, 30.5% palladium, 0.1% manganese and 0.5% iron (melting point = 941° - 977°C). The diamond layer in these samples delaminated, probably because the braze line was too thin.

Accordingly, the experiment was repeated with slight modification as follows. First, the surfaces were lapped before brazing and second, the braze alloy was quenched more rapidly once it became liquid so as to prevent the alloy from seeping out of the diamond/carbide interface. This resulted in a product which did not suffer from the delamination.

EXAMPLE 3

The same tool designs were used to test a braze alloy having a nominal composition of 68.8% silver, 26.7% copper and 4.5% titanium (melting point = 830° - 850°C). The parts were cleaned as in Example 1 and then assembled with the diamond, braze alloy and carbide or ceramic (SIALON type) substrate pressed against one another with a weight on top to ensure adequate contact.

This assembly was placed in a vacuum furnace and heated under a vacuum of about $10^{-4}$ torr for about 1.5 hours to 900°C, held for 15 minutes and quenched. The parts were finished without layer delamination.

Other large diameter tools were prepared in the same manner. The tool blanks were diamond layers attached to cemented carbide substrates. The rough blanks with diamond layer attached were finished by grinding the edges and, in three cases, lapping the diamond surface. None of the samples delaminated. The sizes of these samples were as follows:

80 mm long x irregular width
30 mm x 9 mm
42 mm x 9 mm
60 mm x 19 mm
53 mm x 17 mm
75 mm x 19 mm

The 60 mm x 19 mm sample was further cut by wire EDM cutting the carbide substrate to the diamond layer and snapping the diamond layer along the cut. The diamond did not delaminate and the break followed the EDM cut in the carbide support.

Two 13 mm squares, a 13 mm x 30 mm rectangle and a 6 mm x 53 mm x 56 mm shape were obtained from the original blank. This illustrates the integrity of the bond and the flexibility of obtaining numerous blanks from a larger unit.

Claims

1. A tool comprising a fully dense diamond sheet brazed to a substrate.

2. A tool as set forth in Claim 1, wherein the diamond sheet is manufactured by a chemical vapor deposition process.

3. A tool as set forth in Claim 2, wherein the diamond sheet has a thickness of at least about 0.1 millimeters.

4. A tool as set forth in Claim 3, wherein the longest dimension of the diamond sheet is at least about 30 millimeters.

5. A tool as set forth in Claim 4, wherein the diamond sheet has a thickness of from about 0.1 millimeters to about 1.0 millimeters and a longest dimension of at least about 50 millimeters.

6. A tool as set forth in Claim 1 wherein the substrate is a cemented carbide.

7. A tool as set forth in Claim 6 wherein the diamond sheet is brazed to the cemented carbide substrate with a braze alloy which includes a carbide forming element.

8. A tool as set forth in Claim 7, wherein the carbide forming element is chromium or titanium.

9. A tool consisting essentially of a fully dense, thermally stable diamond sheet manufactured by a chemical vapor deposition process brazed to a cemented carbide substrate with a braze alloy containing a carbide forming element, said diamond sheet having a thickness of at least about 0.1 millimeters and a longest dimension of at least about 50 millimeters.

10. A tool as set forth in Claim 9 which has an irregular shape.

11. A method for making a tool comprising the steps:

(1) machining a diamond sheet made by a low pressure deposition process to dimensions which are approximately equal to those of the substrate to which it is to be brazed;

(2) disposing a braze alloy intermediate said diamond sheet and a substrate;

(3) heating the result of step (2) to a temperature sufficient to at least partly melt said braze alloy;

(4) cooling the composite material which results from step (3); and

(5) machining the diamond layer and/or the substrate of said composite material to substantially the same dimensions.

12. A method as set forth in Claim 11 wherein step (3) is carried out in a vacuum furnace.

13. A method as set forth in Claim 11, further comprising the steps of growing a sheet of diamond on a surface by a chemical vapor deposition process and removing said sheet of diamond from said surface prior to step (1).

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 403 015 (T. NAKAI) <br> * Figure 2; column 1, lines 25-28,50-62; column 2, lines 1-25; column 3, lines 22-40; column 6, line 45 - column 7, line 26; column 7, line 67 - column 8, line 6; examples 3,4 * | 1-13 | B 24 D 3/10 <br> B 24 D 18/00 <br> C 30 B 29/04 <br> C 23 C 16/26 |
| Y,D | US-A-4 707 384 (H. SCHACHNER) <br> * Column 1, lines 7-13; column 2, lines 24-50; column 3, lines 6-41; column 5, lines 18-24; examples 1,3-5; claims 1,3,4,9,10 * | 1-13 | |
| A | US-A-4 247 305 (W. DANIELS) <br> * Column 1, lines 17-58; column 2, lines 5-43 * | 1,6-8 | |
| A,D | EP-A-0 254 560 (SUMITOMO ELECTRIC INC.) <br> * Page 4, lines 11-36; page 6, lines 39-42,51-53; examples 5,6; table 3, samples 27-29 * | 1-13 | TECHNICAL FIELDS SEARCHED (Int. Cl.5) |
| A | US-A-4 380 471 (M. LEE) <br> * Abstract; column 1, lines 28-33; claims 9-11 * | 1,6-8 | B 24 D <br> B 22 F <br> C 23 C <br> C 30 B |
| A,D | US-A-4 224 380 (H. BOVENKERK) <br> * Column 2, lines 8-31; column 3, lines 63-65; column 4, lines 15-31; claims 1,5 * | 1,3-6 | |
| A,D | US-A-4 734 339 (H. SCHACHNER) <br> * Columns 3,4 * | 1,2,6-11 | |
| A | FR-A-2 512 430 (SUMITOMO ELECTRIC IND.) | | |

-/-

The present search report has been drawn up for all claims

| Place of search | Date of completion of the search | Examiner |
|---|---|---|
| THE HAGUE | 21-09-1990 | BOMBEKE M.J.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent Office

**EUROPEAN SEARCH REPORT**

Application Number

EP 90 10 9870

| | **DOCUMENTS CONSIDERED TO BE RELEVANT** | | |
|---|---|---|---|
| Category | Citation of document with indication, where appropriate, of relevant passages | Relevant to claim | CLASSIFICATION OF THE APPLICATION (Int. Cl.5) |
| A,D | EP-A-0 116 403 (DE BEERS)<br>----- | | |
| | | | **TECHNICAL FIELDS SEARCHED (Int. Cl.5)** |
| | The present search report has been drawn up for all claims | | |

| Place of search | Date of completion of the search | Examiner |
|---|---|---|
| THE HAGUE | 21-09-1990 | BOMBEKE M.J.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)